(19) Europäisches Patentamt
European Patent Office
Office européen des brevets

(11) **EP 4 686 696 A1**

(12) **EUROPEAN PATENT APPLICATION**

(43) Date of publication:
04.02.2026 Bulletin 2026/06

(21) Application number: 25189256.8

(22) Date of filing: 14.07.2025

(51) International Patent Classification (IPC):
**B81B 7/02** (2006.01)

(52) Cooperative Patent Classification (CPC):
**B81B 7/02;** B81B 2201/0235; B81B 2201/0242;
B81B 2201/0292; B81B 2207/012; B81C 2203/0154

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 31.07.2024 IT 202400017911

(71) Applicant: STMicroelectronics International N.V.
1228 Plan-les-Ouates, Geneva (CH)

(72) Inventors:
• FALORNI, Luca Giuseppe
20812 Limbiate (MB) (IT)
• MORELLI, Federico
20148 Milano (IT)
• CARMINATI, Roberto
25052 Piancogno (BS) (IT)

(74) Representative: Studio Torta S.p.A.
Via Viotti, 9
10121 Torino (IT)

(54) **PACKAGED MEMS DEVICE HAVING A HUMIDITY SENSOR**

(57) Packaged MEMS device (20) having a MEMS die (24) of semiconductor material formed by a sensor body (31) and a cap (32) mutually bonded. The sensor body (31) incorporates at least one MEMS component (XL, G) and the cap (32) carries a humidity sensor (30) having a first and a second group of electrodes, facing each other and capacitively coupled, configured to provide a humidity signal. A packaging mass (25), of electrically insulating material, surrounds the MEMS die (24) and the humidity sensor (30).

FIG. 3

EP 4 686 696 A1

## Description

<u>Technical Field</u>

The present invention relates to a packaged MEMS device having a humidity sensor.

For example, the following description refers to inertial sensors such as gyroscopes and accelerometers, without however being limited thereto.

<u>Background</u>

As is known, MEMS devices, in particular MEMS devices that implement inertial sensors such as gyroscopes and accelerometers, are usually packaged in a housing of insulating material protecting them from external environmental influences, as well as mechanically protecting and electrically insulating them.

The housing may be made by using different technologies. For example, LGA (Land Grid Array) packages, made by molding a resin mass, are often used to package inertial sensors. This packaging is very widespread since it is cheap, easy to manufacture and able to provide reasonable protection in most cases.

However, this technique does not ensure absolute impermeability to water droplets.

Consequently, in presence of high humidity or, worse, exposure to liquids, some droplets may easily penetrate the housing.

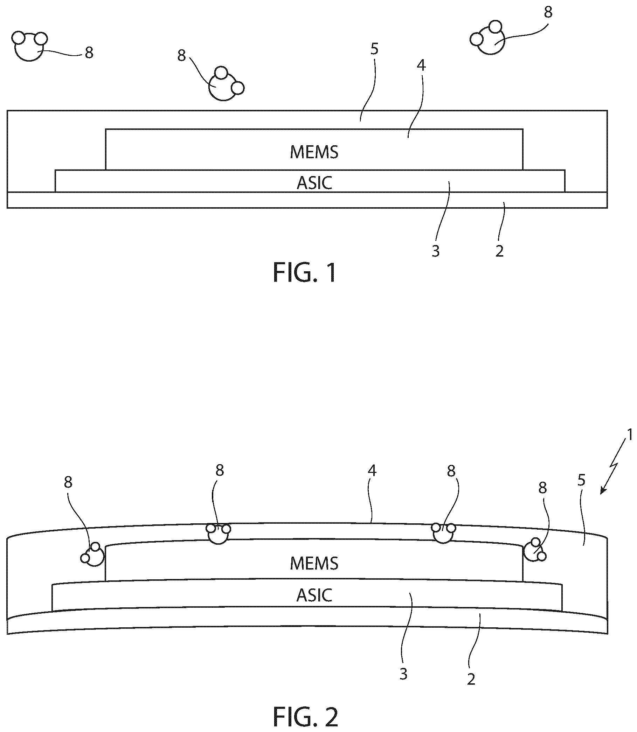

This is disadvantageous, since humidity may cause deformations of both the housing (generating mechanical stress states on the sensor) and the same MEMS sensor, as visible by comparing Figures 1 and 2, schematically showing a section through a packaged MEMS device 1.

In detail, the packaged MEMS device 1 shown in Figures 1 and 2 comprises a support 2, for example a plastic substrate; a first die 3 integrating a signal processing circuit, for example an ASIC (Application Specific Integrated Circuit), hereinafter also simply referred to as ASIC die 3, attached to the support 2; a second die 4 integrating a micro-electro-mechanical, MEMS, system and hereinafter also simply referred to as MEMS die 4, attached to the first die 3; and a packaging mass 5, for example of resin, surrounding the first and the second dice 2, 3 and the exposed upper surface of the support 2.

Figure 1, in particular, shows the packaged MEMS device 1 in the undeformed state; Figure 2 shows the effect of water droplets 8 that penetrate the packaging mass 5 and cause a deformation of both the packaging mass 5 and the underlying structures (support 2, first and second dice 3, 4).

In particular, the stress induced on the MEMS die 4 and the deformations of the same MEMS die 4 may cause errors in the output signals of the MEMS die 4, for example drifts in the reference values, such as the ZRL - Zero Rate Level - value of gyroscopes or the ZGO - Zero Gravity Offset - value of accelerometers, which negatively impact the sensor performances.

To solve this problem, it has already been proposed to associate a humidity sensor to MEMS devices.

However, current commercial humidity sensors have large dimensions, incompatible with those of current MEMS devices. For example, for comparison, typical dimensions of commercial sensors may be of several centimeters, to be compared with millimetric dimensions of MEMS devices. Current humidity sensors cannot therefore be integrated in a same housing with the MEMS die.

US 2016/347606A1 and US 2017/0247247 discloses humidity sensors integrated in an own dice and exposed to the external environment to measure ambient humidity.

The aim of the present invention is to provide a packaged MEMS device incorporating a humidity sensor for detecting humidity and deformation of the device.

<u>Summary</u>

According to the present invention, a packaged MEMS device having a humidity sensor, a method of calibrating a packaged MEMS device and a method of compensating an output signal of a packaged MEMS device are provided, as defined in the appended claims.

<u>Brief Description of the Drawings</u>

For a better understanding of the present invention, embodiments thereof are now described, purely by way of nonlimiting example, with reference to the attached drawings, wherein:

- Figure 1 is a schematic cross-section of an undeformed packaged MEMS device;
- Figure 2 is a schematic cross-sectional view of the packaged MEMS device of Figure 1, in a deformed condition;

- Figure 3 is a top perspective view of the present packaged MEMS device, wherein the package is shown in-ghost;
- Figure 4 is a cross-sectional view of the packaged MEMS device of Figure 3;
- Figure 5 is a cross-sectional view of the present packaged MEMS device, according to another embodiment;
- Figures 6-10 show the plot of quantities relative to the present packaged MEMS device, during test steps;
- Figure 11 is a schematic cross-sectional view of the present packaged MEMS device in presence of humidity and with a compensation unit;
- Figure 12 is a flow chart of a characterization step of the present packaged MEMS device;
- Figures 13 and 14 show the plot of quantities relative to the present packaged MEMS device for compensating the drift of the measured quantities due to humidity; and
- Figure 15 is a flow chart relative to a compensation step of the present packaged MEMS device.

Description of Embodiments

The following description refers to the arrangement shown; consequently, expressions such as "above", "below", "upper", "lower", "right", "left" relate to the attached Figures and are not to be interpreted in a limiting manner.

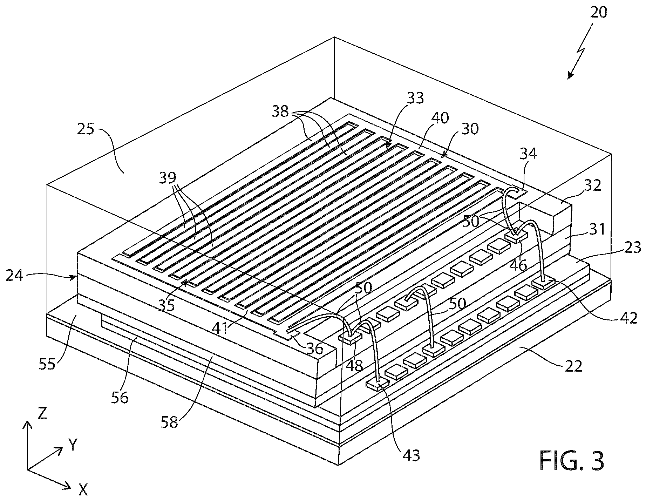

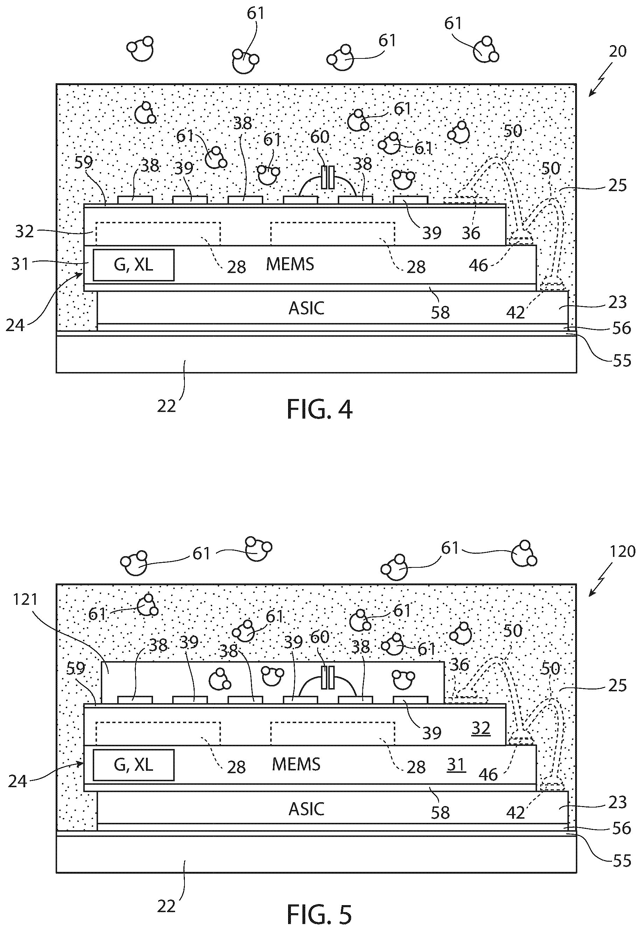

Figures 3 and 4 show a MEMS device 20.

MEMS device 20 comprises a support 22, for example a plastic substrate; a first die 23 of semiconductor material, such as silicon, integrating a signal processing circuit, for example an ASIC (Application Specific Integrated Circuit), hereinafter also simply referred to as ASIC die 23; a second die 24 of semiconductor material, such as silicon, integrating a MEMS - micro-electro-mechanical - system and hereinafter also simply referred to as MEMS die 24; a humidity sensor 30, formed above the MEMS die 24; and a packaging mass 25 (shown in ghost in Figure 3), of electrically insulating material, for example of resin.

The packaging mass 25 surrounds the first and the second dice 23, 24 as well as the humidity sensor 30 and covers the exposed upper surface of the support 22.

In particular, the MEMS device 20 is housed in an LGA (Land Grid Array) package.

In detail, the ASIC die 23 is attached to the support 22 and forms a processing unit that cooperates with the MEMS die 24 executing the tasks envisaged for the MEMS device 20; for example, it receives signals correlated with the displacements of the movable parts of the MEMS die 24 and processes them to obtain position, speed and acceleration information, provided externally. Hereinafter, therefore the term "displacement" means "variation of the measured quantity" or "output of the MEMS die" (e.g. acceleration in case of an accelerometer, angular speed in case of a gyroscope).

The MEMS die 24 is attached to the ASIC die 23 and comprises a sensor body 31 and a cap 32.

The sensor body 31 is formed from a first wafer and integrates one or more inertial sensors, such as a gyroscope and an accelerometer having one or more axes, schematically represented in Figure 4. In particular, in a manner not shown and known to the person skilled in the art, the sensor body 31 comprises fixed parts, integral with the MEMS die 24, movable parts, subject to displacements in presence of external accelerations, and detection structures, configured to generate corresponding displacement signals.

The cap 32 is generally formed from a second wafer, different from the first wafer and is bonded to the sensor body 31; for example, bonding may occur at a wafer level or after dicing the MEMS die 24, in a manner known per se.

The cap 32 may also have one or more cavities facing a respective sensor integrated in the sensor body 31; the cavity/ies (28 in Figures 4 and 5) may be set at a controlled pressure, lower than the atmospheric one, and/or contain particular gases, in a manner know to the person skilled in the art. In case of multiple cavities, they may be at different pressures.

The cap 32 may be electrically coupled to the mass potential of the MEMS die 24, in a manner known per se.

The humidity sensor 30 is formed on the cap 32 and is of a capacitive type, formed by electrodes of conductive material (typically a metal such as aluminum), facing each other.

In detail, the humidity sensor 30 comprises a first group of electrodes 33 coupled to a first sensor pad 34, and a second group of electrodes 35, coupled to a second sensor pad 36.

Each group of electrodes 33, 35 may comprise one or more electrodes.

In particular, in the embodiment shown, the first group of electrodes 33 comprises a plurality of first electrodes 38 and the second group of electrodes 35 comprises a plurality of second electrodes 39, where the first electrodes 38 are interdigitated with the second electrodes 39.

For example, the first and the second electrodes 38, 39 may be formed by equal metal stripes, separated from each other by a gap, whose mutual capacitive coupling is detectable by the ASIC die 23.

In particular, in case of a MEMS die 24 having area 3 x 3 mm$^2$, the first and the second electrodes 38, 39 may have elongated rectangular shape, with a length of 2.5 mm, width comprised between 10 and 20 $\mu$m, gap of 5-10 $\mu$m. In this manner, about 80 strips (80 electrodes between first and second electrodes 38, 39) are obtained.

Furthermore, in case of interdigitated rectangular electrode configuration represented in Figures 3 and 4, a first arm 40 extends transversely to the first electrodes 38 and is coupled to one end thereof; it is also coupled, at one own end, to the first sensor pad 34.

A second arm 41 extends transversely to the second electrodes 39 and is coupled to one end thereof; it is also coupled, at one own end, to the second sensor pad 36.

The first and the second sensor pads 34, 36 are coupled to a first, respectively a second ASIC pad 42, 43 on the ASIC die 23.

In particular, in the embodiment shown, the sensor pads 34, 36 are indirectly coupled to the respective ASIC pads 42, 43.

Precisely, the first sensor pad 34 is coupled to a first MEMS pad 46 formed on the upper surface of the sensor body 31, in a recessed zone of the cap 32; the first MEMS pad 46 is coupled to the first ASIC pad 42; the second sensor pad 36 is coupled to a second MEMS pad 48 formed on the upper surface of the sensor body 31; and the second MEMS pad 48 is coupled to the second ASIC pad 43.

The couplings between the sensor pads 34, 36 and the MEMS pads 46, 48 as well as between the MEMS pads 46, 48 and the ASIC pads 42, 43 occur through wires 50.

Figure 3 also shows further MEMS pads 51 coupled to respective further ASIC pads 52 arranged on the ASIC die 23 through wires 50.

Furthermore, a first insulating layer 55 extends on the surface of support 22; a first bonding layer 56 (for example a "die attach" layer) extends between the first insulating layer 55 and the ASIC die 23; a second bonding layer 58 (for example a "die attach" layer) extends between the ASIC die 23 and the MEMS die 24; and a second insulating layer 59 (not shown in Figure 3, but visible in Figure 4) extends above the MEMS die 24, between the latter and the humidity sensor 30. The second insulating layer 59 is, for example, of silicon oxide.

The humidity sensor 30 may be directly covered by the packaging mass 25, as shown in Figure 4, or may be covered by a humidity sensitive layer, as shown in Figure 5.

In detail, Figure 5 shows a MEMS device 120 having the general structure of the MEMS device 20 of Figure 4 (therefore the common elements are indicated with the same reference numbers), where a humidity sensitive layer 121 covers the humidity sensor 30, leaving exposed the sensor pads 34, 36 (whereof in Figure 4 only the second sensor pad 36 is represented with a dashed line).

The humidity sensitive layer 121 may be for example of polyimide, with a thickness comprised between 1 and 20 $\mu$m.

Figures 4 and 5 show the capacitive coupling between the first and the second electrodes 38, 39, represented by a capacitor 60, and the presence of water droplets 61 penetrated from the outside of the MEMS device 20, 120 and absorbed both by the packaging mass 25 and (for the MEMS device 120 of Figure 5) by the humidity sensitive layer 121.

In Figures 4 and 5 the second insulating layer 59 is also visible and the wires 50 and the MEMS 48 and ASIC pads 43 have been represented in dashed line.

Furthermore, in Figures 4 and 5, by way of example, the sensor body 31 of the MEMS die 24 integrates a gyroscope G and an accelerometer XL.

The MEMS device 20, 120 is formed following the usual MEMS manufacturing techniques; in particular, before or after dicing the ASIC 23 and MEMS dice 24, the second insulating layer 59 is deposited on the surface of the cap 32 and the humidity sensor 30 is formed by depositing and photolithographically defining a metal layer, so as to form the first and the second arms 40, 41, the first and the second electrodes 38, 39, the first and the second sensor pads 34, 36.

Then, wire 50 connections are formed as well as connections to the outside (not shown) and the packaging mass 25 is molded, possibly after forming the humidity sensitive layer 121.

In MEMS devices 20 and 120, when they are exposed to humidity, they may absorb water droplets 61. For example, studies by the Applicant have shown that the resin usually used for packaging is able to absorb water up to 14% of its weight.

Similarly, the polyimide of the humidity sensitive layer 121 has relatively high absorption properties.

When water droplets 61 penetrate within the packaging mass 25 (and possibly the humidity sensitive layer 121), they cause a change in the dielectric constant $\varepsilon_r$ of the layer (25, 121) interposed between the first group of electrodes 33 and the second group of electrodes 35, changing the capacitance of the humidity sensor 30.

The capacitance variation undergone by the humidity sensor 30 may therefore be used as a measure of humidity.

On the other hand, the presence of humidity in the MEMS device 20, 120 causes a deformation of the same MEMS device 20, which may influence the reliability of the measures carried out.

The Applicant has carried out studies that have shown the existence of a correlation between the level of humidity present (and measurable with the humidity sensor 30) and the deformation undergone; such correlation may therefore be exploited to compensate the measures acquired by the MEMS device 20, 120.

In particular, studies by the Applicant have shown that, in some situations, the capacitance modification of the humidity sensor 30 is approximately proportional to the amount of absorbed water.

To this end, a test MEMS device formed as the MEMS device 20 has been introduced in a test environment where a humidity level that is controlled and increasing over time has been created.

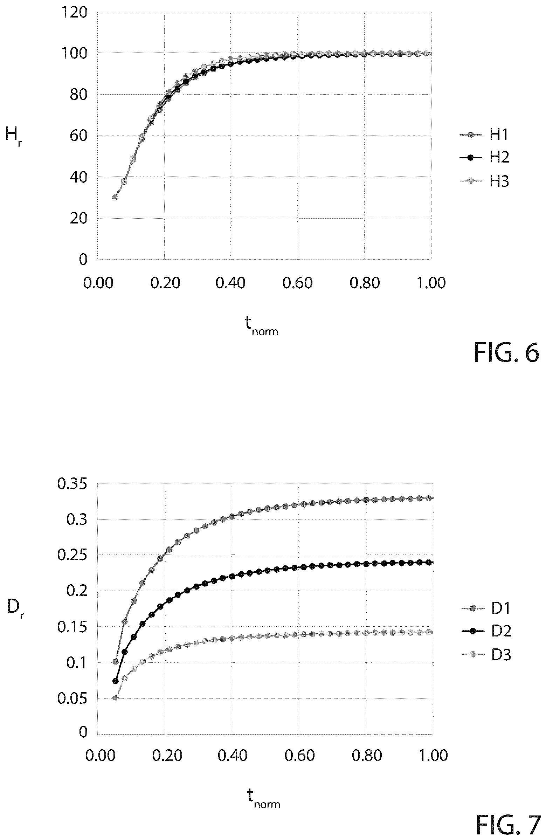

Under these conditions, the humidity trend detected in three points of the cap 32 and the corresponding displacement of three points of the sensor die 31 underlying the three points where the relative humidity Hr has been extracted have been simulated, as shown in Figure 6 (showing curves of relative humidity Hr -referenced as H1, H2, H3- as a function of the normalized time $t_{norm}$) and in Figure 7 (relative deformation measures $D_r$ -referenced as D1, D2, D3-).

These simulations have been repeated on multiple MEMS devices 20, 120 and have demonstrated the existence of a significant correlation between the signal measured by the humidity sensor 30 and the deformation of the MEMS device 20 in case the humidity time constant ($\tau_h$) and the device deformation time constant ($\tau_{def}$) are approximately similar.

Further studies have also shown that similar trends of the humidity time constant and of the deformation are obtained when the volume of the packaging mass 25 of the MEMS device 20, 120 (possibly including also the humidity sensitive layer 121) is comprised between about 30% and 50% of the total volume of the MEMS device 20, 120, i.e., indicating the volume of the packaging mass 25 as $V_r$ and the total volume of the MEMS device 20, 120 as $V_{tot}$, it is:

$$0.3 < V_r/V_{tot} < 0.5 \qquad\qquad (1).$$

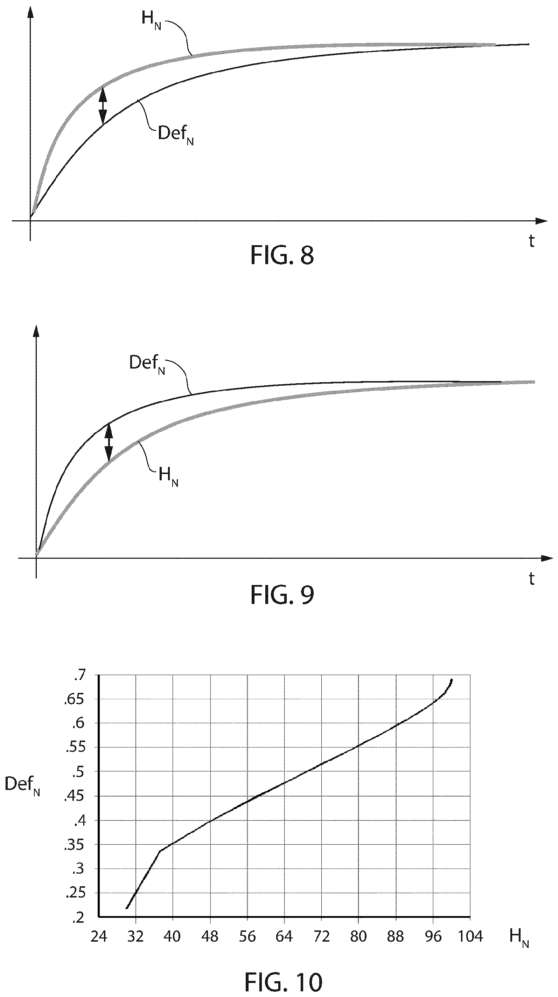

In fact, it has been seen that, when the ratio $V_r/V_{tot}$ is lower than 30%, the humidity signal measured by the humidity sensor 30 reaches a steady state very quickly, before the deformation of the MEMS device 20 occurs, see Figure 8. This behavior has been interpreted as due to the fact that the amount of water that penetrates the packaging mass 25 from the top of the MEMS device 20 quickly reaches the humidity sensor 30 and saturates it immediately.

Furthermore, it has been seen that, when the volume of the packaging mass 25 $V_r$ is greater than 50% of the total volume $V_{tot}$, the humidity signal measured by the humidity sensor 30 follows the deformation variation with a delay, see Figure 9. This behavior has been interpreted as due to the fact that the deformation is caused by to the drops that penetrate from the sides of the MEMS device 20 rather than from the top where the humidity sensor 30 is located, thereby the latter registers the increase in humidity with a delay with respect to the amount of drops that penetrate the packaging mass 25 and cause the deformation.

In both cases, when the packaging mass 25 is too small or too large compared to the dimensions of the MEMS device 20, 120, the humidity measures do not correctly and promptly represent the deformation and therefore are not a reliable index usable in the compensation, at least in some operating conditions.

Conversely, within the range defined by the relationship (1), the studies by the Applicant have shown that the average displacement measured as a function of humidity has an approximately linear trend, as shown in Figure 10 where $Def_N$ represents the normalized deformation and $H_N$ indicates the normalized humidity, in arbitrary units.

Under such conditions, a reliable compensation of the drift of the measure signal provided by the MEMS die 24, for example the angular speed value measured by the gyroscope G and/or the acceleration measured by the accelerometer XL, may be carried out.

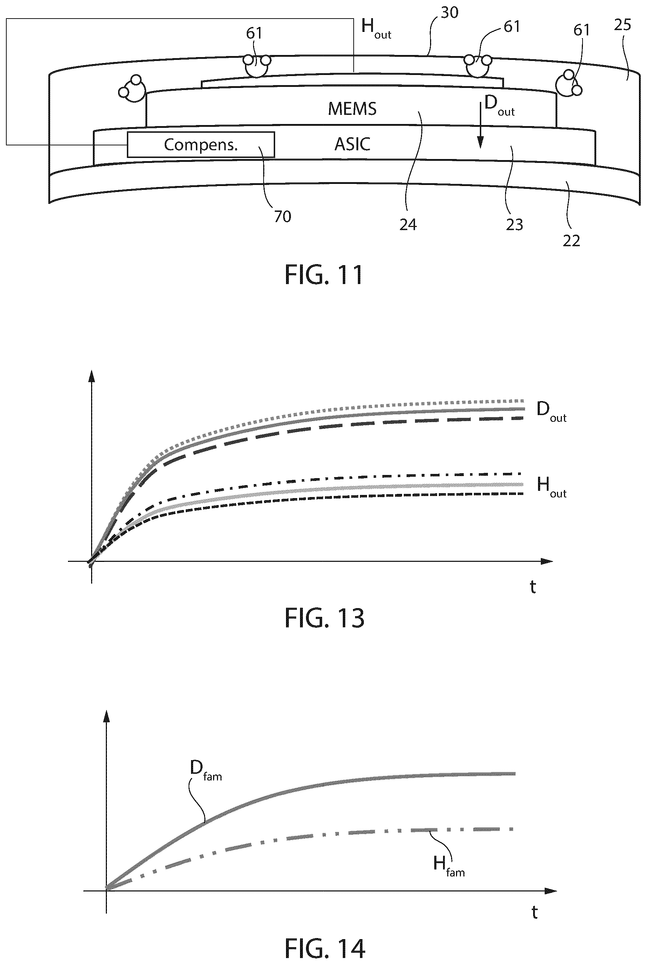

Figure 11 schematically shows a MEMS device 20, which deforms due to the presence of water droplets (still indicated by 61). The humidity information obtainable through the humidity sensor 30 (humidity signal $H_{out}$) is provided to a compensation part 70 formed in the ASIC die 24.

The compensation part 70 also receives the measure results of the inertial sensors implemented in the MEMS die 23 (measure signals $D_{out}$) and compensates the values measured on the basis of the humidity signal $H_{out}$, as described in detail below.

It should be noted that the humidity signal $H_{out}$ does not directly represent the existing humidity value but, as indicated above, measures the capacitance variation between the groups of electrodes 38, 39; however, since this is uniquely correlated to humidity, as discussed above, hereinafter the term "humidity signal $H_{out}$" means a humidity signal, which is uniquely correlated to the measured humidity and may be used directly for compensation, as discussed in detail below.

Studies by the Applicant have also shown that the single MEMS devices 20, 120 have similar, but not exactly coincident, trends in the humidity-displacement correlation, due to manufacturing tolerances of the MEMS die 23 and/or differences in the mounting parameters of the dice 23, 24 to the support 22 and/or other factors.

For allowing the MEMS device 20, 120 to operate reliably under all work conditions, according to an aspect of the present disclosure, an initial calibration procedure is performed, executed at assembling batch level on a series of MEMS devices 20 during the final test step.

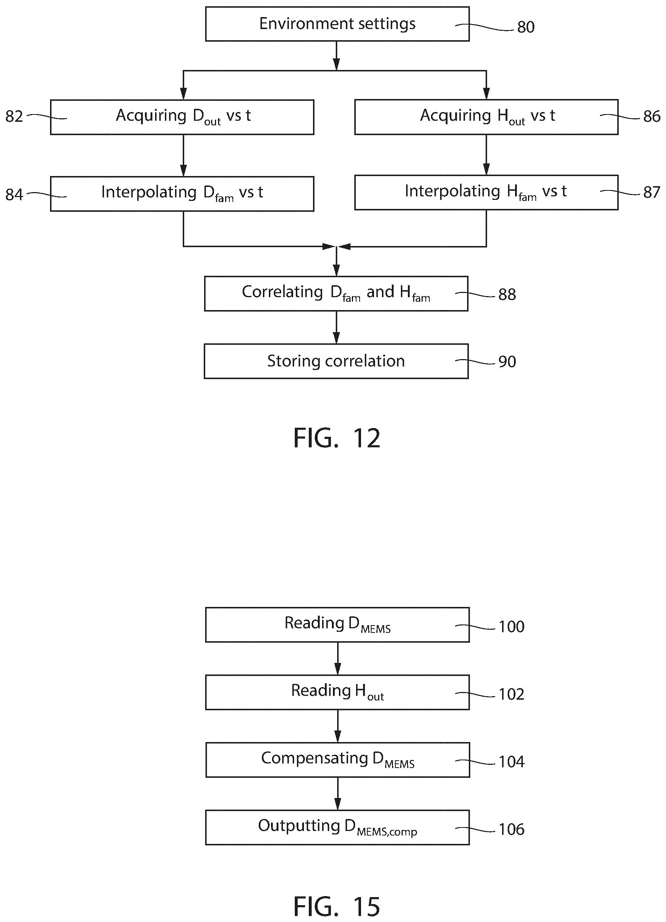

In detail, the calibration procedure, see Figure 12, is performed by introducing a plurality of MEMS devices 20, 120 in a controlled humidity environment, where water drops are gradually introduced, so as to have a gradual and controlled increase in the humidity level, block 80.

During the calibration procedure, the MEMS devices 20 are maintained without external accelerations (apart from gravity), for measuring for example the ZRL - Zero Rate Level - value of the gyroscopes or the ZGO - Zero Gravity Offset - value of the accelerometers.

During the humidity increase step, the calibration system (not shown, typically an external calibration apparatus coupled to the ASIC die 23) acquires the measures $D_{out}$ of the tested MEMS devices 20, 120, block 82; performs an interpolation of the acquired measures $D_{out}$, block 84; acquires the humidity information (humidity signals $H_{out}$) provided by the humidity sensors 30 of each tested MEMS device 20, block 86; and performs an interpolation of the humidity signals $H_{out}$, block 87.

For example, in block 82, the calibration system (not shown) samples the measure signals $D_{out}$ (whose plots over time are shown for sake of illustration in Figure 13) and, in block 86, simultaneously samples the humidity signals $H_{out}$ generated by the respective humidity sensors 30 (whose plots over time are also shown for sake of illustration in Figure 13) .

It should be noted that the measure signals $D_{out}$ sampled and acquired by the calibration system (not shown) represent the outputs of the MEMS dice 24, not yet processed by the respective ASIC dice 23.

Furthermore, in block 84, the measure signals $D_{out}$, sampled at the same instant in the different tested MEMS devices 20, 120, are interpolated to obtain an average trend of the family of tested MEMS devices 20, 120, as shown for example in Figure 14 (curve of the measure interpolated values $D_{fam}$).

For example, the interpolation may comprise the calculation of the average value among the samples of the measure signals $D_{out}$ acquired at the same instant, or other suitable type of interpolation.

Similarly, in block 86, the corresponding samples of the humidity signal $H_{out}$ are acquired and, in block 87, interpolated humidity values $H_{fam}$ are calculated (Figure 14).

The acquisition step of the samples of the measure signals $D_{out}$ and the corresponding humidity signals $H_{out}$ as well as interpolation step (blocks 82-87) are carried out for a predetermined time, for example as long as the acquired samples have significant variability, or for a predetermined time, for example a few hours.

At the end of the steps of blocks 82-87, the calibration system (not shown) creates a correlation between the measure interpolated values $D_{fam}$ and the interpolated humidity values $H_{fam}$, associating the relative values, block 88, and then stores the correlation, block 90, for example in a table stored in the ASIC dice 23 of the tested MEMS devices 20, 120.

The interpolated values $D_{fam}$ may then be used as corrective factors of the measures carried out during real-time operation of each MEMS device 20, 120 as shown in the flow chart of Figure 15.

In detail, during real-time operation, in each single MEMS device 20, 120, the compensation part 70 acquires a real-time measure value $D_{MEMS}$ from the die 24, according to the desired operating modes, block 100; acquires the corresponding value of the humidity signal $H_{out}$, provided by the humidity sensor 30, block 102; performs the compensation of the real-time measure value $D_{MEMS}$ just acquired on the basis of the compensation value $D_{fam}$ stored at the same value of the acquired humidity signal $H_{out}$, block 104, obtaining a compensated value $D_{MEMS,comp}$; and, possibly after further processing of the compensated signal by the ASIC die 23, according to the foreseen procedures, sends the thus obtained compensated value $D_{MEMS,comp}$ outside the MEMS device 20, 120, block 106.

The MEMS device, the calibration method and the operating method described herein have numerous advantages.

The humidity sensor 30 may be formed directly on the cap 32 of the MEMS die 24 using established micromanufacturing techniques and thus in an inexpensive and reliable manner.

The integrated manufacture of the humidity sensor 30 within the MEMS device 20, 120 allows for a simplified design, which also favors a possibility for real-time performance compensation.

The described MEMS device has high sensitivity thanks to the maximization of the capacity obtainable with the humidity sensor 30 formed directly on the cap, in particular when a drop of humidity rests on the electrodes, also by virtue of the small dimensions of the gap (obtainable through lithographic processes) between the electrodes 38, 39.

The pattern of the electrodes 38, 39 is highly customizable due to the high flexibility of the obtainable geometry, by simply modifying the photolithographic mask defining the groups of electrodes 33, 35.

The sensitivity of the humidity sensor may be easily tailored to the MEMS applications/sensors implemented in the MEMS die 24, increasing the adaptability of the MEMS device to the needs of the user/customer.

Finally, it is clear that modifications and variations may be made to the packaged MEMS device, the calibration method and the operating method described and illustrated herein without thereby departing from the scope of the present invention, as defined in the attached claims.

For example, the support 22 might be absent and/or the type of package might be different, for example of the QFN type with a different substrate.

As indicated above, the number, shape and dimensions of the electrodes 38, 39 may vary.

The acquisition of the humidity value $H_{out}$ during the calibration step, block 80, may be carried out on a single device 20, 120.

**Claims**

1. A packaged MEMS device (20; 120) comprising:

a MEMS die (24) of semiconductor material, including a sensor body (31) and a cap (32) mutually bonded, the sensor body (31) incorporating at least one MEMS component (XL, G);

a humidity sensor (30), extending on the cap (32) and including a first and a second group of electrodes, facing each other and capacitively coupled, configured to provide a humidity signal; and

a packaging mass (25), of electrically insulating material, completely enclosing the MEMS die (24) and the humidity sensor (30),

the first and the second groups of electrodes (33, 35) comprising each at least one electrode (38, 39).

2. The packaged MEMS device according to claim 1, wherein the first and the second groups of electrodes (33, 35) each comprise a plurality of mutually interdigitated electrodes (38, 39).

3. The packaged MEMS device according to claim 1 or 2, wherein the first and the second groups of electrodes (33, 35) are of metal.

4. The packaged MEMS device according to any of the preceding claims, further comprising a humidity sensitive layer (121) covering the humidity sensor (30) and extending between the humidity sensor (30) and the packaging mass (25).

5. The packaged MEMS device according to the preceding claim, wherein the packaging mass (25) comprises resin and the humidity sensitive layer (121) comprises polyimide.

6. The packaged MEMS device according to any of the preceding claims, wherein the volume ratio $V_r/V_{tot}$ meets the following relationship:

$$0.3 < V_r/V_{tot} < 0.5,$$

wherein $V_r$ is the volume of the packaging mass (25) and $V_{tot}$ is the total volume of the MEMS device (20; 120).

7. The packaged MEMS device according to any of the preceding claims, further comprising a processing die (23) integrating a processing unit, wherein the sensor body (31) is bonded to the processing die (23) and the first and the second groups of electrodes (33, 35) are connected to the processing unit (24).

8. The packaged MEMS device according to the preceding claim, wherein the first and the second groups of electrodes (33, 35) are coupled each to a respective sensor pad (34, 36) arranged on the cap (32), and the sensor pads (34, 36) are coupled to corresponding processor pads (42, 43) arranged on the processing die (23).

9. The packaged MEMS device according to the preceding claim, wherein the sensor pads (34, 36), are coupled to corresponding MEMS pads (46, 48) arranged on the sensor body (31) and the MEMS pads (46, 48) are coupled to corresponding processor pads (42, 43), wherein the coupling between the sensor pads (34, 36), the MEMS pads (46, 48) and the processor pads (42, 43) is a wire (50) coupling.

10. The packaged MEMS device according to any of claims 7-9, wherein the processing unit comprises a calibration unit (70), wherein the calibration unit (70) comprises:

means (100) for acquiring a MEMS signal ($D_{MEMS}$) from the MEMS die (24);
means (102) for acquiring a humidity signal ($H_{out}$) from the humidity sensor (30); and
means (104) for compensating the MEMS signal ($D_{MEMS}$) on the basis of the humidity signal ($H_{out}$).

11. The packaged MEMS device according to any of the preceding claims, wherein the MEMS component (XL, G) is an inertial sensor, such as an accelerometer and/or a gyroscope.

12. A method for calibrating a packaged MEMS device (20; 120) according to any of the preceding claims, comprising:

introducing (80) the packaged MEMS device (20; 120) into an environment having a controlled humidity level;
gradually modifying (80) the humidity level in the environment;
capacitively measuring (86) humidity changes ($H_{out}$) between the first and the second groups of electrodes (33, 35) of the MEMS device (20; 120) while gradually modifying the humidity level;

acquiring (82) an output signal ($D_{out}$) of the MEMS component (XL, G) of the MEMS device (20; 120) while gradually modifying the humidity level;

generating a correlation between the acquired output signal ($D_{out}$) and the measured humidity changes ($H_{out}$);

storing (90) the correlation.

13. The method according to the preceding claim, wherein the MEMS device is a first MEMS device, the method further comprising:

introducing (80) into the environment at least one further MEMS device (20; 120) according to any of claims 1-9;

capacitively measuring (86) humidity changes ($H_{out}$) between the first and the second groups of electrodes of the further MEMS device while gradually modifying the humidity level;

acquiring (82) a further output signal ($D_{out}$) of the further MEMS device (20; 120) while gradually modifying (80) the humidity level;

interpolating (84) an output correction value on the basis of the output signal ($D_{out}$) of the first MEMS device and the further output signal ($D_{out}$) of the MEMS component of the further MEMS device to obtain interpolated correction information ($D_{fam}$);

storing (90) the interpolated correlation information as a function of the measured humidity changes.

14. A method for compensating an output signal of a packaged MEMS device (20; 120) according to any of claims 1-11, comprising, in an operative phase of the MEMS device:

acquiring (100) the output signal ($D_{MEMS}$) from the sensor body (31);

acquiring (102) the humidity signal ($H_{out}$) from the humidity sensor (30); and

compensating (104) the output signal ($D_{MEMS}$) on the basis of the humidity signal ($H_{out}$) using a stored correlation between the output signal and the humidity signal.

15. The method according to the preceding claim, wherein acquiring (102) the humidity signal ($H_{out}$) comprises detecting capacitance variations between the first and the second groups of electrodes (33, 35) of the packaged MEMS device (20; 120).

MEMS

ASIC

**FIG. 1**

MEMS

ASIC

**FIG. 2**

FIG. 3

FIG. 4

FIG. 5

FIG. 6

FIG. 7

FIG. 8

FIG. 9

FIG. 10

FIG. 11

FIG. 13

FIG. 14

Environment settings — 80

82 — Acquiring $D_{out}$ vs t

Acquiring $H_{out}$ vs t — 86

84 — Interpolating $D_{fam}$ vs t

Interpolating $H_{fam}$ vs t — 87

Correlating $D_{fam}$ and $H_{fam}$ — 88

Storing correlation — 90

## FIG. 12

Reading $D_{MEMS}$ — 100

Reading $H_{out}$ — 102

Compensating $D_{MEMS}$ — 104

Outputting $D_{MEMS,comp}$ — 106

## FIG. 15

Europäisches
Patentamt

European
Patent Office

Office européen
des brevets

# EUROPEAN SEARCH REPORT

**Application Number**

EP 25 18 9256

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/347606 A1 (BRUNO GIUSEPPE [IT] ET AL) 1 December 2016 (2016-12-01) | 1-3,6-9 | INV. B81B7/02 |
| Y | * figures 2,6 * | 10,12-15 | |
| A | | 4,5 | |
| | ----- | | |
| X | US 2017/247247 A1 (ZHANG QING [CA] ET AL) 31 August 2017 (2017-08-31) | 1,11 | |
| Y | * figure 22 * | 10,12-15 | |
| | ----- | | |
| Y | EP 3 239 681 A1 (SENSIRION AG [CH]) 1 November 2017 (2017-11-01) * figures 10,12,13 * * paragraphs [0075], [0076] * | 10,12-15 | |
| | ----- | | |
| A | US 10 184 910 B2 (BOSCH TOOL CORP [US]; BOSCH GMBH ROBERT [DE]) 22 January 2019 (2019-01-22) * figure 4 * | 4,5 | |
| | ----- | | |

**TECHNICAL FIELDS SEARCHED (IPC)**

B81B
B81C

The present search report has been drawn up for all claims

| Place of search | Date of completion of the search | Examiner |
|---|---|---|
| Berlin | 22 September 2025 | McGinley, Colm |

EPO FORM 1503 03.82 (P04C01)

## ANNEX TO THE EUROPEAN SEARCH REPORT
## ON EUROPEAN PATENT APPLICATION NO.

EP 25 18 9256

This annex lists the patent family members relating to the patent documents cited in the above-mentioned European search report.
The members are as contained in the European Patent Office EDP file on
The European Patent Office is in no way liable for these particulars which are merely given for the purpose of information.

22-09-2025

| Patent document cited in search report | | Publication date | Patent family member(s) | | Publication date |
|---|---|---|---|---|---|
| US 2016347606 | A1 | 01-12-2016 | CN | 106185783 A | 07-12-2016 |
| | | | CN | 205442631 U | 10-08-2016 |
| | | | EP | 3098195 A1 | 30-11-2016 |
| | | | US | 2016347606 A1 | 01-12-2016 |
| US 2017247247 | A1 | 31-08-2017 | CN | 107121461 A | 01-09-2017 |
| | | | EP | 3211409 A1 | 30-08-2017 |
| | | | US | 2017247247 A1 | 31-08-2017 |
| EP 3239681 | A1 | 01-11-2017 | NONE | | |
| US 10184910 | B2 | 22-01-2019 | EP | 2912426 A2 | 02-09-2015 |
| | | | US | 2014116122 A1 | 01-05-2014 |
| | | | WO | 2014066768 A2 | 01-05-2014 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016347606 A1

- US 20170247247 A